# FASCICULE DE BREVET EUROPEEN

(11) **EP 4 466 966 B1**
(45) Date de publication et mention de la délivrance du brevet: **03.12.2025**
(21) Numéro de dépôt: 23700212.6
(22) Date de dépôt: 11.01.2023
(51) Int. Cl.: H10N 30/073

(54) **PROCÉDÉ DE FABRICATION D'UN SUBSTRAT DONNEUR POUR LE TRANSFERT D'UNE COUCHE PIÉZOÉLECTRIQUE ET PROCÉDÉ DE TRANSFERT D'UNE COUCHE PIÉZOÉLECTRIQUE SUR UN SUBSTRAT SUPPORT**
VERFAHREN ZUR HERSTELLUNG EINES DONORSUBSTRATS ZUR ÜBERTRAGUNG EINER PIEZOELEKTRISCHEN SCHICHT UND VERFAHREN ZUR ÜBERTRAGUNG EINER PIEZOELEKTRISCHEN SCHICHT AUF EIN TRÄGERSUBSTRAT
METHOD FOR PRODUCING A DONOR SUBSTRATE FOR TRANSFERRING A PIEZOELECTRIC LAYER, AND METHOD FOR TRANSFERRING A PIEZOELECTRIC LAYER TO A CARRIER SUBSTRATE

(30) Priorité: 17.01.2022 FR 2200381
(43) Date de publication de la demande: 27.11.2024
(73) Titulaire: SOITEC, 38190 Bernin (FR)
(72) Inventeur: BROEKAART, Marcel, 38190 Bernin (FR); CHARLES-ALFRED, Cedric, 38190 Bernin (FR); CAPELLO, Luciana, 38190 Bernin (FR); LOGIOU, Morgane, 38190 Bernin (FR); BARGE, Thierry, 38190 Bernin (FR)
(74) Mandataire: IP Trust
(86) Numéro de dépôt international: PCT/EP2023/050567
(87) Numéro de publication internationale: WO 2023/135179

(56) Documents cités:
- EP-A1- 3 306 644
- EP-A1- 3 930 429
- WO-A1-2015/008658
- WO-A1-2017/052646
- WO-A1-2019/186032

## Description

L'invention concerne un procédé de fabrication d'un substrat donneur pour le transfert d'une couche piézoélectrique et un procédé de transfert d'une telle couche piézoélectrique sur un substrat support.

Un substrat piézoélectrique sur isolant (POI) comprend une couche mince de matériau piézoélectrique sur un substrat. Pour fabriquer un tel substrat POI, le procédé utilisé comprend le transfert de la couche mince piézoélectrique sur un substrat support à partir d'un substrat épais de matériau piézoélectrique.

Pour cela, d'abord un substrat donneur est utilisé dans lequel un substrat massif de matériau piézoélectrique est assemblé à un substrat de manipulation par collage en utilisant une couche polymère. Ensuite, le substrat donneur subit une étape d'amincissement du substrat massif piézoélectrique pour former une couche piézoélectrique plus mince avant d'être assemblé au substrat support. Finalement, le transfert de la couche piézoélectrique sur le substrat support est réalisé de manière mécanique ou thermique au niveau d'une zone de fracturation crée au préalable dans la couche piézoélectrique amincie. Le substrat donneur est introduit dans le procédé pour limiter l'impact négatif de la différence des coefficients de dilatation thermique entre le matériau piézoélectrique et le substrat support du POI. En effet, pour renforcer l'interface de collage entre les différents substrats et pour le transfert de la couche mince, des traitements thermiques sont réalisés. Un exemple de ce type de procédé est décrit dans WO 2019/186032 A1. Des autres exemples de l'art antérieur sont décrits par WO 2015 / 008658 A1, WO 2017 / 052646 A1, EP 3 306 644 A1 et EP 3 930 429 A1. Aucun de ces documents ne divulgue une combinaison d'une couche polymère et une étape d'activation d'une surface d'un substrat piézoélectrique venant en contact avec la couche polymère telle que définie par les revendications indépendantes.

Ainsi, lors du procédé de fabrication d'un substrat POI, le substrat donneur doit subir plusieurs étapes de traitements thermiques et/ou mécaniques et doit présenter une bonne tenue mécanique aux différents traitements.

Cependant, un décollage au niveau de l'interface de collage entre le substrat de matériau piézoélectrique et la couche polymère du substrat donneur peut se produire lors des étapes thermiques et/ou mécaniques successives du procédé de transfert de couche piézoélectrique. Un but de l'invention est de remédier aux inconvénients précités et notamment de concevoir un substrat donneur pour le transfert d'une couche piézoélectrique d'un substrat de matériau piézoélectrique sur un substrat support qui présente une meilleure tenue mécanique pour le procédé de transfert de couche piézoélectrique.

L'objet de l'invention est réalisé par un procédé de fabrication d'un substrat donneur pour le transfert d'une couche piézoélectrique sur un substrat support comprenant les étapes de fournir un substrat de manipulation, en particulier un substrat à base de silicium, fournir un substrat piézoélectrique, déposer une couche polymère sur une face libre du substrat piézoélectrique, assembler le substrat piézoélectrique sur le substrat de manipulation de telle manière que la couche polymère est positionnée en sandwich entre le substrat piézoélectrique et le substrat de manipulation, caractérisé en ce que une étape de traitement d'activation de surface de la surface du substrat piézoélectrique venant en contact avec la couche polymère est réalisée avant l'étape d'assemblage du substrat piézoélectrique sur le substrat de manipulation.

Un traitement de surface est une opération mécanique, chimique, électrochimique ou physique qui a pour but de modifier l'aspect ou la fonction de la surface des matériaux afin de les adapter à une utilisation donnée. Un traitement de surface permet la fonctionnalisation, l'activation ou le nettoyage de la surface, ou une combinaison de ces effets. Ainsi, l'étape de traitement de surface du substrat piézoélectrique dans le procédé selon l'invention permet de modifier l'aspect ou la fonction de la surface du substrat piézoélectrique afin de l'adapter au contact avec la couche polymère, pour obtenir une meilleure interface entre le matériau piézoélectrique et la couche polymère. Ainsi, le procédé selon l'invention permet d'obtenir un substrat donneur ayant une stabilité mécanique améliorée par rapport à l'état de l'art.

Selon un mode de réalisation, lors de l'étape de dépôt d'une couche polymère sur le substrat piézoélectrique, la couche polymère peut être déposée directement sur la surface traitée du substrat piézoélectrique. La surface traitée du substrat piézoélectrique permet d'offrir une meilleure adhésion à la couche polymère qui va être déposée dessus. Ainsi, seule la couche polymère permet de réaliser une bonne adhésion du substrat piézoélectrique à une autre couche ou un autre substrat. Une couche polymère peut être déposée par exemple par un procédé de déposition par centrifugeuse directement sur le substrat piézoélectrique.

L' objet de l'invention est aussi réalisé par un procédé de fabrication d'un substrat donneur pour le transfert d'une couche piézoélectrique sur un substrat support comprenant les étapes de fournir un substrat de manipulation, en particulier un substrat à base de silicium, fournir un substrat piézoélectrique, déposer une couche polymère sur une face libre du substrat de manipulation, assembler le substrat piézoélectrique sur le substrat de manipulation de telle manière que la couche polymère est positionnée en sandwich entre le substrat piézoélectrique et le substrat de manipulation, caractérisé en ce que une étape de traitement d'activation de la surface du substrat piézoélectrique venant en contact avec la couche polymère du substrat de manipulation lors de l'étape d'assemblage est réalisée avant l'étape d'assemblage du substrat piézoélectrique sur le substrat de manipulation.

De même, l'étape de traitement de surface du substrat piézoélectrique dans le procédé selon l'invention permet de modifier l'aspect ou la fonction de la surface du substrat piézoélectrique afin de l'adapter au contact avec la couche polymère du substrat de manipulation, pour obtenir une meilleure interface entre le matériau piézoélectrique et la couche polymère. Ainsi, le procédé selon l'invention permet d'obtenir un substrat donneur ayant une stabilité mécanique améliorée par rapport à l'état de l'art.

Selon un mode de réalisation, lors de l'étape de dépôt d'une couche polymère sur le substrat de manipulation, la couche polymère peut être positionnée directement sur le substrat de manipulation. La couche polymère seule permet de réaliser une bonne adhésion à une autre couche ou un autre substrat. Une couche polymère peut être déposée par exemple par un procédé de déposition par centrifugeuse directement sur le substrat de manipulation.

Selon un mode de réalisation, l'étape d'assemblage du procédé de fabrication d'un substrat donneur peut comprendre une étape de traitement de la couche polymère pour obtenir une couche polymère réticulée pour coller le substrat de manipulation au substrat piézoélectrique. La formation d'une couche polymère réticulée par une étape de traitement de la couche polymère est simple à mettre en œuvre et est peu coûteuse.

Selon un mode de réalisation, l'étape de traitement d'activation de surface peut être un traitement d'activation de surface à base d'oxygène créant des liaisons pendantes sur la surface du substrat piézoélectrique venant en contact avec la couche polymère. Le traitement d'activation de surface à base d'oxygène consiste en une oxydation de la surface d'un matériau. L'oxydation des molécules de surface permet d'augmenter la tension de surface d'un support. Le traitement d'activation de surface à base d'oxygène permet la création de radicaux libres en surface qui favorisent l'adhésion d'une couche mince en contact avec ces radicaux libres.

Selon un mode de réalisation, l'étape de traitement d'activation de surface du substrat piézoélectrique peut être un traitement à l'ozone, en particulier par voie humide ou assistée par UV. Un traitement à l'ozone est un traitement qui permet de modifier la surface du substrat piézoélectrique pour améliorer l'interface entre la couche polymère et la surface du substrat piézoélectrique.

Selon un mode de réalisation, l'étape de traitement d'activation de surface du substrat piézoélectrique peut être un traitement par une solution à base de peroxyde d'hydrogène. Un traitement par une solution à base de peroxyde d'hydrogène permet de modifier la surface du substrat piézoélectrique pour améliorer l'interface entre la couche polymère et la surface du substrat piézoélectrique.

Selon un mode de réalisation, l'étape de traitement d'activation de surface du substrat piézoélectrique peut être un traitement par plasma, en particulier par plasma à base d'oxygène. Le traitement de surface plasma est un traitement par voie sèche qui permet d'améliorer les caractéristiques chimiques du matériau pour une meilleure adhésion à une couche de revêtement. Ainsi, l'étape de traitement par plasma du procédé selon l'invention permet d'améliorer l'adhérence entre la couche polymère et la surface du substrat piézoélectrique du substrat donneur, et résulte en une stabilité mécanique du substrat donneur améliorée par rapport à l'état de l'art.

Selon un mode de réalisation, le substrat piézoélectrique peut être un substrat de Tantalate de Lithium (LTO), de Niobate de Lithium (LNO), de Nitrure d'Aluminium (AIN), de Titano-Circonate de Plomb (PZT), de Langasite ou de Langatate. Le procédé selon l'invention peut être utilisé pour ces matériaux, qui jouent un rôle majeur dans les dispositifs exploitant l'effet piézoélectrique.

Selon un mode de réalisation, une étape d'amincissement du substrat piézoélectrique du substrat donneur peut être réalisée après l'étape d'assemblage, en particulier après l'étape de traitement de la couche polymère de l'étape d'assemblage, de manière à obtenir soit un substrat piézoélectrique aminci avec une épaisseur *t* inférieure à l'épaisseur *t₁* du substrat piézoélectrique, soit une couche piézoélectrique d'une épaisseur *t₂* inférieure à l'épaisseur *t₁* du substrat piézoélectrique. Ainsi, à partir d'un substrat épais piézoélectrique, un substrat piézoélectrique plus mince ou une couche piézoélectrique d'une épaisseur voulue est obtenu/e et le substrat donneur fabriqué selon le procédé de l'invention peut être utilisé comme substrat donneur pour le transfert d'une couche piézoélectrique mince sur un substrat support pour obtenir un substrat piézoélectrique sur isolant (POI).

Dans un procédé de fabrication d'un substrat POI, le matériau piézoélectrique et le matériau du substrat support présentant des coefficients de dilatation thermique très différents, une déformation importante de l'assemblage survient. Dans un tel procédé, grâce à l'usage d'un substrat donneur, le substrat piézoélectrique épais est maintenu entre le substrat de manipulation et le substrat support. Le choix des matériaux et des épaisseurs du substrat de manipulation et du substrat support permet d'assurer une certaine symétrie des coefficients de dilatation thermique, et ainsi de minimiser la déformation de l'assemblage lors l'application de traitements thermiques lors du procédé de fabrication d'un substrat piézoélectrique sur isolant (POI).

L'objet de l'invention peut aussi être réalisé par un procédé de transfert d'une couche piézoélectrique sur un substrat support comprenant les étapes de fournir un substrat donneur obtenu par le procédé de fabrication décrit auparavant, former une zone de fragilisation à l'intérieur du substrat piézoélectrique, fournir un substrat support, en particulier un substrat à base de silicium, attacher le substrat donneur au substrat support pour obtenir un assemblage substrat support - substrat donneur, et réaliser la fracture le long de la zone de fragilisation pour séparer une couche piézoélectrique du restant du substrat donneur. Dans un procédé de fabrication d'un substrat POI, le matériau piézoélectrique et le matériau du substrat support présentant des coefficients de dilatation thermique très différents, une déformation importante de l'assemblage survient. Dans un tel procédé, grâce à l'usage d'un substrat donneur, le substrat piézoélectrique épais est maintenu entre le substrat de manipulation et le substrat support. Le choix des matériaux et des épaisseurs du substrat de manipulation et du substrat support permet d'assurer une certaine symétrie des coefficients de dilatation thermique, et ainsi de minimiser la déformation de l'assemblage lors l'application de traitements thermiques lors du procédé de fabrication d'un substrat piézoélectrique sur isolant (POI).

L'invention et ses avantages seront expliqués plus en détail dans la suite au moyen de modes de réalisation préférés et en s'appuyant notamment sur les figures d'accompagnement suivantes, dans lesquelles les numéros de référence identifient des caractéristiques de l'invention.
[Figure 1] représente schématiquement un procédé de fabrication d'un substrat donneur selon un premier mode de réalisation de l'invention.
[Figure 2] représente schématiquement un procédé de fabrication d'un substrat donneur selon une variante du premier mode de réalisation de l'invention.
[Figure 3] représente schématiquement un procédé de fabrication d'un substrat donneur selon un deuxième mode de réalisation de l'invention.
[Figure 4] représente schématiquement un procédé de transfert d'une couche piézoélectrique selon un troisième mode de réalisation de l'invention.

L'invention va être décrite plus en détail en utilisant des modes de réalisation avantageux d'une manière exemplaire et en référence aux dessins. Les modes de réalisation décrits sont simplement des configurations possibles et il faut garder à l'esprit que les caractéristiques individuelles telles que décrites ci-dessus peuvent être fournies indépendamment les unes des autres ou peuvent être omises tout à fait lors de la mise en œuvre de la présente invention.

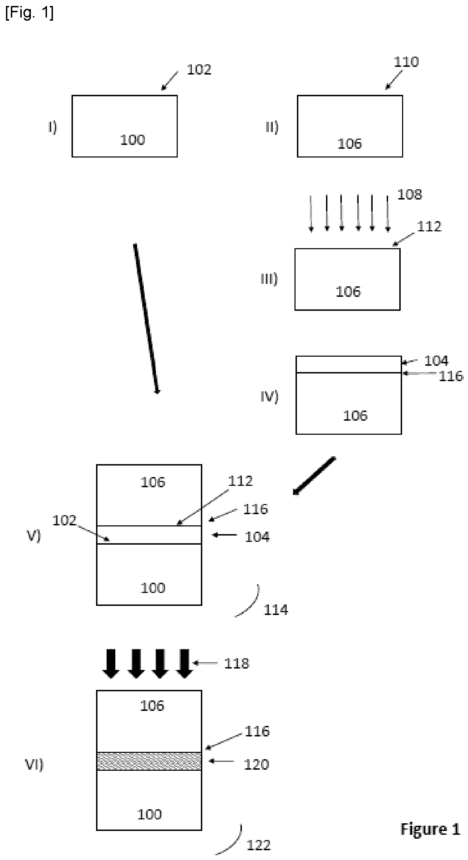

La Figure 1 illustre schématiquement un procédé de fabrication d'un substrat donneur utilisé pour le transfert d'une couche piézoélectrique du substrat donneur sur un substrat support selon un premier mode de réalisation de l'invention.

Le procédé de fabrication d'un substrat donneur commence par l'étape I) de fournir un substrat de manipulation 100, en particulier un substrat massif. Un substrat massif est un substrat à base d'un seul matériau typiquement d'une épaisseur comprise entre 300µm et 800µm. Le substrat de manipulation 100 est d'un matériau dont le coefficient de dilatation thermique est proche de celui du matériau du substrat support sur lequel la couche piézoélectrique est destinée à être transférée. Par « proche », on entend une différence de coefficient de dilatation thermique entre le matériau du substrat de manipulation 100 et le matériau du substrat support inférieure ou égale à 5%, et de préférence égale ou voisine de 0%. Le substrat de manipulation 100 peut être un substrat à base de silicium, de saphir, de nitrure d'aluminium (AIN), de carbure de silicium (SiC) ou encore d'arséniure de gallium (GaAs). Le substrat de manipulation 100 peut être un substrat cristallin ou poly cristallin.

Lors de l'étape II) du procédé selon le premier mode de réalisation, un substrat piézoélectrique 106 est fourni. Il s'agit de préférence d'un substrat massif de matériau piézoélectrique, dont l'épaisseur est typiquement de l'ordre d'au moins 300µm, de préférence d'au moins 350µm. Selon une variante, le substrat de matériau piézoélectrique 106 peut aussi être une couche épaisse de matériau piézoélectrique d'une épaisseur comprise entre 25µm et 50µm, déposée sur un autre substrat.

Le matériau piézoélectrique peut, par exemple, être du Tantalate de Lithium (LTO), du Niobate de Lithium (LNO), du Nitrure d'Aluminium (AIN), du Titano-Circonate de Plomb (PZT), de la Langasite ou du Langatate.

Le substrat piézoélectrique 106 peut subir d'abord une ou plusieurs étapes de nettoyage, de brossage ou de polissage de sa surface libre 110 pour enlever les particules ou poussière et ainsi obtenir une surface libre 110 propre et de bonne qualité pour réaliser par la suite un dépôt de couche successif.

Selon l'invention, le substrat piézoélectrique 106 subit ensuite une étape III) de traitement de surface 108 sur l'une de ses surface libre 110 pour obtenir une surface activée 112.

Le traitement de surface 108 de la surface 110 du substrat piézoélectrique 106 est un traitement qui permet l'activation de la surface à traiter. Un tel traitement d'activation de surface 108 permet de préparer la surface d'un matériau pour un contact avec une couche successive soit lors d'un dépôt successif, soit lors d'une mise en contact avec un autre substrat. Pour cela, le traitement d'activation de surface 108 modifie les propriétés de la surface. Un traitement d'activation de surface peut être mécanique, chimique, électrochimique ou physique.

Le traitement d'activation de surface 108 peut être un traitement d'activation de surface à base d'oxygène. L'oxydation des molécules de surface permet d'augmenter la tension de surface d'un support créant des liaisons pendantes sur la surface. Le traitement d'activation de surface 108 à base d'oxygène permet la création de radicaux libres en surface qui favorisent l'adhésion d'une couche mince en contact avec ces radicaux libres. Ainsi, la surface activée 112 du substrat piézoélectrique 106 comprend des liaisons pendantes. Ces liaisons pendantes représentent des sites de liaisons qui permettent d'obtenir une meilleure liaison avec la surface d'un matériau mis en contact avec les liaisons pendantes. En effet, les liaisons pendantes de la surface activée 112 du substrat piézoélectrique 106 vont réaliser des liaisons covalentes avec les liaisons pendantes de la surface du matériau mis en contact avec la surface activée 112 du substrat piézoélectrique 106.

Selon un mode de réalisation, l'étape III) de traitement d'activation de surface 108 du substrat piézoélectrique 106 peut être est un traitement à l'ozone, en particulier par voie humide ou assistée par UV. La présence d'ozone permet d'oxyder les molécules de surface. L'usage de l'irradiation par UV permet de créer des radicaux libres.

Selon un autre mode de réalisation, l'étape III de traitement d'activation de surface 108 du substrat piézoélectrique 106 peut être un traitement par une solution à base de peroxyde d'hydrogène. Le traitement au peroxyde d'hydrogène est aussi connu comme traitement à oxygène actif, et permet la formation de radicaux libres par oxydation.

Selon un autre mode de réalisation, l'étape III de traitement d'activation de surface 108 du substrat piézoélectrique 106 peut être un traitement par plasma, en particulier par plasma à base d'oxygène. Un traitement par plasma est un traitement par voie sèche qui permet l'activation de la surface. Le traitement de surface plasma consiste en une très forte oxydation de la surface d'un matériau.

Ainsi, le traitement de surface 108 du procédé selon l'invention permet d'améliorer les caractéristiques chimiques de la surface 112 du substrat piézoélectrique 106 en créant des sites de liaisons pour une meilleure adhésion à une couche qui est déposée ou mise en contact avec la surface activée 112 du substrat piézoélectrique 106 à posteriori dans le procédé.

Une étape IV) de dépôt d'une couche polymère 104 sur la surface activée 112 du substrat piézoélectrique 106 est ensuite réalisée.

Le dépôt de la couche polymère 104 est avantageusement effectué par enduction centrifuge, ou « spin coating » en terminologie anglosaxonne. Cette technique consiste à faire tourner le substrat sur lequel est prévu le dépôt de la couche polymère sur lui-même à une vitesse donnée, afin d'étaler ladite couche polymère 104 de façon uniforme sur l'ensemble de la surface libre 112 du substrat piézoélectrique 106 par force centrifuge. A cet effet, le substrat piézoélectrique 106 est typiquement posé et maintenu par tirage du vide sur un plateau tournant. L'épaisseur de la couche de polymère 104 obtenue dépend des paramètres utilisés lors du dépôt de la couche, c'est à dire par exemple de la vitesse et de la durée de rotation du substrat et du volume de la solution polymère déposée sur la surface 112 du substrat 106. L'épaisseur de la couche polymère 104 est typiquement comprise entre 1 µm et 6µm, de préférence de l'ordre de 3.5µm.

La couche polymère 104 peut être une couche photo-polymérisable à base de résine thiol-ène. Par exemple, la couche commercialisée sous la référence « NOA 61 » par la société NORLAND PRODUCTS peut être utilisée dans la présente invention comme couche polymère 104.

Lors de l'étape de dépôt de la couche polymère 104, la couche polymère 104 est déposée directement en contact avec la surface activée 112 du substrat piézoélectrique 106.

La surface libre 110 du substrat piézoélectrique 106 a subi auparavant l'étape de traitement de surface 108 pour une activation de la surface libre 110 et ainsi obtenir une bonne adhésion de la couche polymère 104 sur la surface libre 110 du substrat piézoélectrique 106.

Ainsi, les liaisons pendantes présentes sur la surface activée 112 du substrat piézoélectrique 106 créent des sites de liaisons favorisant l'adhérence de la couche polymère 104 formée sur la surface activée 112 du substrat piézoélectrique 106. Les liaisons pendantes présentes sur la surface activée 112 du substrat piézoélectrique 106 vont former des liaisons covalentes avec les liaisons pendantes de la couche polymère 104. Ainsi, l'interface de contact 116 entre le substrat piézoélectrique 106 et la couche polymère 104 est consolidée/renforcée.

Après le dépôt par centrifugeuse de la couche polymère 104 sur le substrat piézoélectrique 106, un traitement thermique peut être réalisé pour améliorer l'adhésion de la couche polymère 104 à la surface activée 112 du substrat piézoélectrique 106 à l'interface 116.

Le substrat piézoélectrique 106 obtenu après l'étape IV, est ensuite assemblé au substrat de manipulation 100 fourni à l'étape I) durant une étape V) d'assemblage pour obtenir un substrat donneur 114.

L'assemblage du substrat piézoélectrique 106 sur le substrat de manipulation 100 est fait telle que la couche polymère 104 est positionnée en sandwich entre le substrat piézoélectrique 106 et le substrat de manipulation 100.

L'interface de contact 116 entre le substrat piézoélectrique 106 et la couche polymère 104 est consolidée/renforcée et résulte en une stabilité mécanique du substrat donneur 114 améliorée par rapport à l'état de l'art.

Une fois les deux substrats assemblés, une étape VI) de collage est réalisée pour coller le substrat piézoélectrique 106 au substrat de manipulation 100 pour former un substrat donneur 122 stable.

La couche polymère 104 subit un traitement de réticulation 118 de la couche polymère 104 pour modifier les propriétés mécaniques de la couche polymère 104. La réticulation est le terme général désignant le processus de formation de liaisons covalentes ou de séquences relativement courtes de liaisons chimiques pour joindre deux chaînes polymères. Lorsque les chaînes polymères sont réticulées, la couche polymère 104 devient plus rigide. Les réticulations chimiques covalentes sont stables mécaniquement et thermiquement, de sorte qu'une fois formées, elles sont difficiles à rompre.

Un traitement de réticulation 118 peut être réalisé par usage de chaleur, de pression, par un changement de pH ou par de l'irradiation. Selon l'invention, le traitement de réticulation 118 peut être réalisé par irradiation par un flux lumineux 118 de la couche polymère 104. L'irradiation 118 est réalisée à travers le substrat piézoélectrique 106 ou le substrat 100 pour réticuler la couche polymère 104 et obtenir une couche polymère réticulée 120 ou également appelée couche polymérisée 120.

L'irradiation 118 du substrat donneur 114 est réalisée à l'aide d'une source lumineuse, de préférence un laser. Le rayonnement lumineux 118, ou flux lumineux, est de préférence un rayonnement ultra-violet (UV), de préférence d'une longueur d'onde comprise entre 320nm et 365nm.

L'épaisseur de la couche polymère réticulée 120 est de préférence comprise entre 1µm et 6.5µm, en particulier environ 3.5µm. Cette épaisseur dépend notamment du matériau de la couche polymère 104 déposée avant collage, de l'épaisseur de ladite couche polymère et des conditions d'irradiation.

La réticulation de la couche polymère 104 par irradiation UV 118 permet de libérer des radicaux qui vont déclencher la polymérisation de la couche polymère 104. La polymérisation de la couche polymère 104 résulte en des liaisons chimiques qui sont stables mécaniquement et thermiquement, de sorte qu'une fois formées, elles sont difficiles à rompre. Ainsi, la liaison entre les liaisons pendantes de la surface activée 112 du substrat piézoélectrique 106 et la couche polymère réticulée 120 résulte en une liaison stable mécaniquement et thermiquement.

La couche polymérisée 120 assure ainsi la cohésion mécanique du substrat donneur 122, en maintenant collés ensemble le substrat de manipulation 100 et le substrat piézoélectrique 106 qui forment le substrat donneur 122.

Grace au traitement d'activation de surface 108, l'interface 116 entre la couche polymère réticulée 120 et le substrat piézoélectrique 106 présente une amélioration de l'adhérence entre la couche polymère 120 et la surface du substrat piézoélectrique 106, le substrat donneur 122 ainsi obtenu par le procédé de fabrication selon l'invention présente une stabilité mécanique améliorée à l'interface polymère - piézoélectrique.

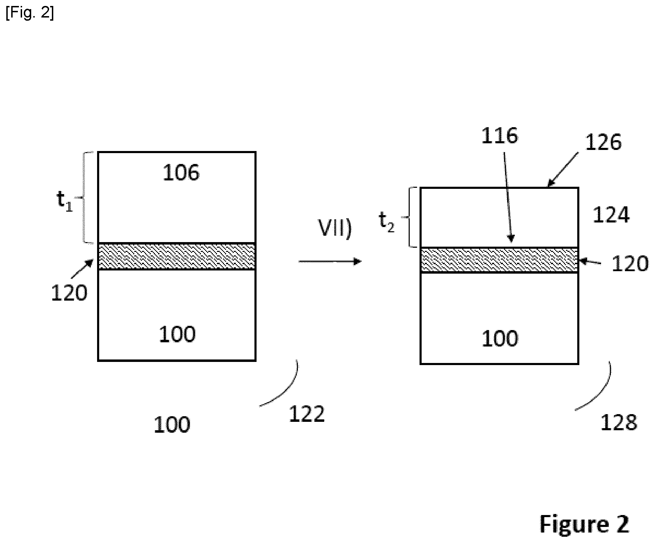

La Figure 2 représente schématiquement un procédé de fabrication d'un substrat donneur pour le transfert d'une couche piézoélectrique sur un substrat support selon une variante du premier mode de réalisation de l'invention. Toutes les caractéristiques communes avec le premier mode de réalisation et utilisant le même numéro de référence que ci-dessus ne seront pas décrites à nouveau, mais il est fait référence à leur description détaillée ci-dessus.

Le procédé selon le premier mode de réalisation comprend après l'étape VI) illustré dans la Figure 1 une étape d'amincissement VII) du substrat piézoélectrique 106 du substrat donneur 122 obtenu selon le procédé du premier mode de réalisation.

Cette étape d'amincissement VII) peut être réalisée par un procédé de meulage ou bien par un procédé de gravure chimique du substrat piézoélectrique 106 pour réduire l'épaisseur *t₁* du substrat de matériau piézoélectrique 106 du substrat donneur 122 pour obtenir soit un substrat piézoélectrique aminci 140 d'une épaisseur *t* inférieure à *t₁*, soit une couche piézoélectrique 124 d'une épaisseur *t₂* de l'ordre de 20µm, ou encore entre 5µm et 25µm.

Un traitement de la surface libre 126 de la couche piézoélectrique 124 obtenue peut aussi être réalisé une fois l'étape d'amincissement VII) terminée pour améliorer la qualité de la surface libre 126 de la couche piézoélectrique 124.

Etant donné la stabilité mécanique du substrat donneur 122 obtenu par le procédé selon le premier mode de réalisation, les étapes d'amincissement et de traitement subit par le substrat donneur 122 peuvent être réalisées sans que l'interface 116 polymère-piézoélectrique ne soit affectée par ces étapes mécaniques et/ ou thermique et le risque de décollage à cette interface 116 est réduit, en particulier annulé. Ainsi, le substrat donneur 128 obtenu montre une stabilité mécanique qui lui permet d'être utilisé en amont dans un procédé de transfert de couche piézoélectrique 124 sur un substrat support 140.

Un substrat donneur 128 est ainsi obtenu avec une couche polymère réticulée 120 positionnée entre un substrat de manipulation 100 et une couche piézoélectrique 124, le substrat de manipulation 100 étant en contact avec la couche polymère réticulée 120 de la couche piézoélectrique 124.

L'assemblage du substrat de manipulation 100 soit avec le substrat piézoélectrique 106 soit, après amincissement de ce dernier comme décrit dans le paragraphe précédent, avec la couche piézoélectrique 124, selon les modes de réalisation décrits, peut avoir un intérêt non seulement comme substrat donneur 122, 128 mais peut constituer un substrat en soi qui peut servir pour la fabrication de composants acoustiques.

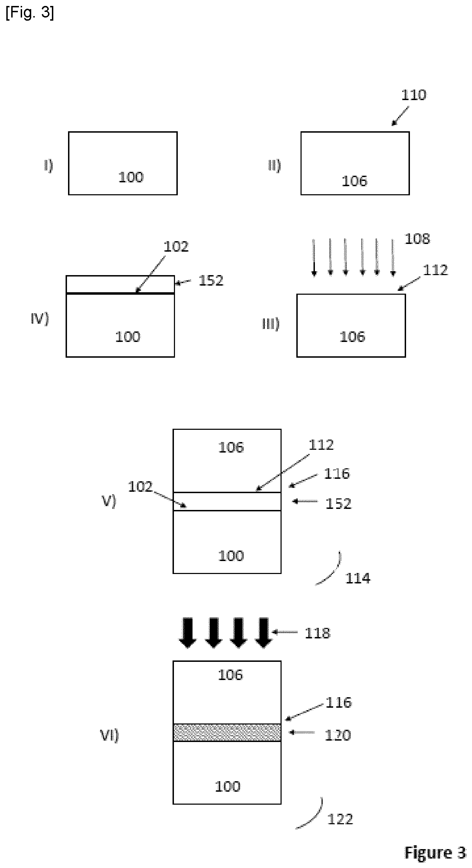

La figure 3 montre le second mode de réalisation de l'invention dans lequel l'étape de dépôt IV) de la couche polymère 152 est différente par rapport au premier mode de réalisation. L'étape de dépôt de la couche polymère 152 est réalisée sur le substrat de manipulation 100. Toutes les autres étapes I, II, III et V à VII sont les mêmes que dans le premier mode de réalisation et sa variante. Toutes les caractéristiques communes avec le premier mode de réalisation et utilisant le même numéro de référence que ci-dessus ne seront pas décrites à nouveau, mais il est fait référence à leur description détaillée ci-dessus.

Lors de l'étape de dépôt IV) de la couche polymère, la couche polymère 152 est déposée directement en contact avec la surface libre 102 du substrat de manipulation 100. Le substrat de manipulation 100 peut subir d'abord une ou plusieurs étapes de nettoyage, de brossage ou de polissage de sa surface libre 102 pour enlever les particules ou poussière et ainsi obtenir une surface libre 102 propre et de bonne qualité pour réaliser par la suite le dépôt de la couche polymère 152.

Lors de l'étape V) d'assemblage, la couche polymère 152 du substrat de manipulation 100 est mise en contact direct avec la surface activée 112 du substrat piézoélectrique 106. Ainsi, l'interface 116 de contact entre la couche polymère 152 et la surface activée 112 du substrat piézoélectrique 106 présente aussi une meilleure adhésion. En effet, de la même façon que précédemment décrit, les liaisons pendantes présentes sur la surface activée 112 du substrat piézoélectrique 106 créent des sites de liaisons favorisant l'adhérence de la couche polymère 152 formée sur le substrat de manipulation 100 avec la surface activée 112 du substrat piézoélectrique 106. Ainsi, l'interface de contact 116 entre le substrat piézoélectrique 106 et la couche polymère 152 est consolidée/renforcée et résulte en une stabilité mécanique du substrat donneur 114 améliorée par rapport à l'état de l'art.

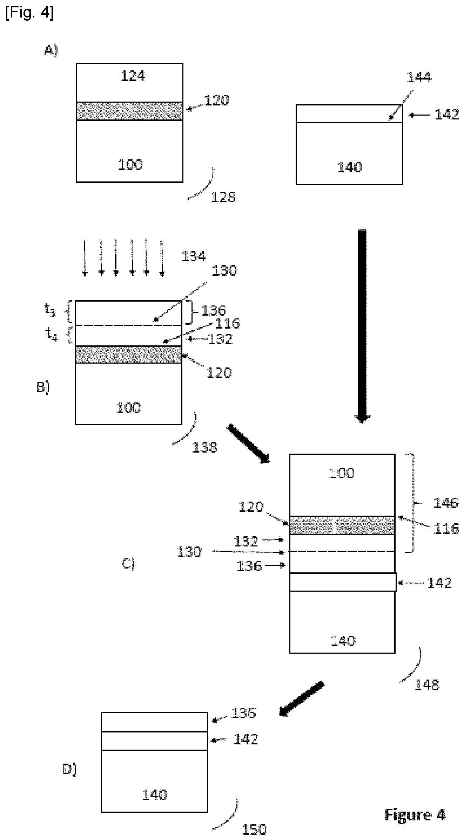

La Figure 4 représente schématiquement un procédé de transfert d'une couche piézoélectrique selon un troisième mode de réalisation de l'invention.

Le procédé de transfert d'une couche piézoélectrique sur un substrat support selon l'invention comprend l'étape de fournir un substrat donneur obtenu par la mise en œuvre du procédé de fabrication d'un substrat donneur décrit par rapport aux Figures 1 à 3 selon le premier mode de réalisation de l'invention et sa variante et selon le deuxième mode de réalisation de l'invention et sa variante.

Lors de l'étape A) le substrat donneur 128 et le substrat support 140 sont fournis.

Le substrat support 140 peut être un substrat massif à base de silicium, de saphir, de nitrure d'aluminium (AIN), de carbure de silicium (SiC) ou encore d'arséniure de gallium (GaAs). Le substrat support 140 peut être un substrat cristallin ou poly cristallin.

Comme illustré à la figure 4, le substrat support 140 peut comprendre une couche diélectrique 142 antérieurement déposé sur la surface libre 144 du substrat support 140 par un dépôt par centrifugeuse ou par une technique de déposition telle que déposition plasma ou évaporation. Un traitement thermique peut aussi être réalisé après le dépôt de la couche diélectrique 142 pour optimiser l'adhérence de cette couche diélectrique 142 au substrat support 140, ou encore un traitement de surface pour améliorer la qualité de la surface de la couche diélectrique 142 déposée.

Dans une variante, le substrat support 140 peut comprendre une couche d'oxyde naturel qui est formée sur la surface libre 144 du substrat support 140.

La couche diélectrique 142 est par exemple une couche de silicium de dioxyde. Mais la couche diélectrique 142 peut aussi être une couche de nitrure, ou une couche comprenant une combinaison de nitrure et d'oxyde, ou une superposition d'une couche d'oxyde et d'une couche de nitrure. Par exemple, dans le cas d'un substrat support en silicium, on pourra former une couche d'oxyde, ou une couche de nitrure Si₃N₄, une couche comprenant une combinaison de nitrure et d'oxyde SiOₓN_{y}, ou une superposition d'une couche d'oxyde et d'une couche de nitrure Si₃N₄.

Dans une variante, le substrat support 140 peut aussi comprendre d'autres couches. Par exemple, des couches pour réaliser un miroir de Bragg ou une couche de piégeage peut/peuvent être présente sur le substrat support 140. En particulier, une couche de piégeage de type silicium polycristallin, amorphe ou poreux peut être présente, d'une épaisseur variant entre 500nm et 5µm.

Dans une variante, le substrat support 140 est fourni sans couche diélectrique 142 et/ou sans couche d'oxyde naturel.

Dans une variante, une couche diélectrique peut être fournie sur la couche piézoélectrique 132 du substrat donneur 138 au lieu d'être fournie sur le substrat support 140.

Dans une autre variante, une couche diélectrique peut être fournie sur les deux substrats, le substrat donneur 128 et sur le substrat support 140.

Une étape B) de former une zone de fragilisation 130 dans la couche piézoélectrique 124 du substrat donneur 128 est réalisée de manière à délimiter la couche piézoélectrique 132 à transférer sur le substrat support 140.

Cette étape de formation d'une zone de fragilisation 130 est réalisée par une implantation 134 d'espèces atomiques ou ioniques dans la couche piézoélectrique 124 du substrat donneur 128. L'implantation atomique ou ionique 134 est réalisée de telle manière que la zone de fragilisation 130 est située à l'intérieure de la couche piézoélectrique 124 et sépare une couche piézoélectrique 136 du reste 132 de la couche piézoélectrique 124. Les espèces atomiques ou ioniques sont implantées à une profondeur déterminée de la couche piézoélectrique 124 qui détermine l'épaisseur *t₃* de la couche piézoélectrique 136 à transférer et l'épaisseur *t₄* du reste 132 de la couche piézoélectrique 124. L'épaisseur *t₃* est typiquement entre 50nm et 1µm, en particulier de l'ordre de 600nm.

Le substrat donneur 138 obtenu comprend une zone de fragilisation 130 séparant la couche piézoélectrique 136 à transférer du reste 132 de la couche piézoélectrique 124.

L'étape C) du procédé de transfert selon l'invention comprend assembler le substrat donneur 138 au substrat support 140 pour obtenir un assemblage substrat support - substrat donneur qui forme l'hétérostructure 148. L'assemblage du substrat donneur 138 avec le substrat support 140 se fait au niveau de la couche diélectrique 142, de telle manière que la couche piézoélectrique 136 du substrat donneur 138 est en contact avec la couche diélectrique 142 du substrat support 140.

Dans la variante ou le substrat support 140 ne comprend pas de couche diélectrique 142, l'assemblage se fait de telle manière que la couche piézoélectrique 136 du substrat donneur 148 est en direct contact avec la surface libre 144 du substrat support 140. L'assemblage se fait par adhésion moléculaire entre les deux substrats, à l'interface piézoélectrique - substrat support.

Dans une variante, l'assemblage du substrat donneur 138 avec le substrat 140 se fait entre la couche diélectrique 142 et une couche diélectrique formée sur le substrat donneur 140 comme mentionné ci-dessus. Cette couche diélectrique est par exemple une couche d'oxyde de silicium, une couche de nitrure de silicium Si₃N₄ ou une couche comprenant une combinaison de nitrure et d'oxyde de silicium encore appelé oxynitrure de silicium SiOₓN_{y}, ou une superposition d'une couche d'oxyde et d'une couche de nitrure. Selon une variante, la formation de cette couche diélectrique peut être suivie d'un traitement thermique pour améliorer l'l'adhérence de la couche diélectrique a la couche piézoélectrique 124. Un traitement de surface pour améliorer la qualité de la surface de cette couche diélectrique peut également être réalisé, en particulier après l'étape d'implantation 134 et avant l'étape C) mentionnée ci-dessus.

Ensuite, une étape D) de réaliser une fracture le long de la zone de fragilisation 130 du substrat donneur 148 pour séparer la couche piézoélectrique 136 du restant 146 du substrat donneur 148 est réalisée. Cette étape de fracture peut être réalisée thermiquement ou mécaniquement. Lors d'une séparation thermique, la température utilisée est égale ou inférieure à 300°C.

L'utilisation du substrat donneur 128 fabriqué selon l'invention permet d'éviter un décollement entre la couche piézoélectrique 124 et la couche polymère 120 du substrat donneur 128 lors de la fracturation du substrat donneur 128, grâce à l'interface 116 entre la couche polymère 120 et la couche piézoélectrique 124 comprenant une meilleure stabilité mécanique. Cela permet d'obtenir une fracture efficace du substrat donneur 148 à la zone de fragilisation 130 pour obtenir un substrat POI 150.

Le substrat POI 150 illustré à l'étape D) de la Figure 4 est réalisé par le procédé de transfert d'une couche piézoélectrique selon l'invention et comprend un substrat support 140, une couche diélectrique 142 et une couche piézoélectrique 136.

Les modes de réalisation décrits sont simplement des configurations possibles et il faut garder à l'esprit que les caractéristiques individuelles des différents modes de réalisation peuvent être combinées entre elles ou fournies indépendamment les unes des autres.

## Revendications

1. Procédé de fabrication d'un substrat donneur pour le transfert d'une couche piézoélectrique sur un substrat support (140) comprenant les étapes de:
- fournir un substrat de manipulation (100), en particulier un substrat à base de silicium,
- fournir un substrat piézoélectrique (106),
- déposer une couche polymère (104) sur une surface libre (110) du substrat piézoélectrique (106)
- assembler le substrat piézoélectrique (106) sur le substrat de manipulation (100) de telle manière que la couche polymère (104) est positionnée en sandwich entre le substrat piézoélectrique (106) et le substrat de manipulation (100),
**caractérisé en ce que**
une étape de traitement d'activation (108) de surface de la surface (110) du substrat piézoélectrique (106) venant en contact avec la couche polymère (104) est réalisée avant l'étape d'assemblage du substrat piézoélectrique (106) sur le substrat de manipulation (100).

2. Procédé de fabrication d'un substrat donneur selon la revendication 1, dans lequel la couche polymère (104) est déposée directement sur la surface activée (112) du substrat piézoélectrique (106).

3. Procédé de fabrication d'un substrat donneur pour le transfert d'une couche piézoélectrique sur un substrat support (140) comprenant les étapes de:
- fournir un substrat de manipulation (100), en particulier un substrat à base de silicium,
- déposer une couche polymère (152) sur une surface libre (102) du substrat de manipulation (100),
- assembler un substrat piézoélectrique (106) sur le substrat de manipulation (100) de telle manière que la couche polymère (152) est positionnée en sandwich entre le substrat piézoélectrique (106) et le substrat de manipulation (100),
**caractérisé en ce que**
une étape de traitement d'activation (108) de surface de la surface (110) du substrat piézoélectrique (106) venant en contact avec la couche polymère (152) du substrat de manipulation (100) lors de l'étape d'assemblage est réalisée avant l'étape d'assemblage du substrat piézoélectrique (106) sur le substrat de manipulation (100).

4. Procédé de fabrication d'un substrat donneur selon la revendication 3, dans lequel, lors de l'étape de dépôt de la couche polymère (152), la couche polymère (152) est positionnée directement sur le substrat de manipulation (100).

5. Procédé de fabrication d'un substrat donneur selon une des revendications 1 à 4, dans lequel l'étape d'assemblage comprend une étape de traitement (108) de la couche polymère (104, 152) pour obtenir une couche polymère réticulée (120) pour coller le substrat de manipulation (100) au substrat piézoélectrique (106).

6. Procédé de fabrication d'un substrat donneur selon une des revendications 1 à 5, dans lequel l'étape de traitement d'activation de surface (108) est un traitement d'activation de surface (108) à base d'oxygène créant des liaisons pendantes sur la surface (110) du substrat piézoélectrique (106) venant en contact avec la couche polymère (104, 152).

7. Procédé de fabrication d'un substrat donneur selon une des revendications 1 à 6, dans lequel l'étape de traitement d'activation de surface (108) du substrat piézoélectrique (106) est un traitement à l'ozone, en particulier par voie humide ou assistée par UV.

8. Procédé de fabrication d'un substrat donneur selon une des revendications 1 à 6, dans lequel l'étape de traitement d'activation de surface (108) du substrat piézoélectrique (106) est un traitement par solution à base de peroxyde d'hydrogène.

9. Procédé de fabrication d'un substrat donneur selon une des revendications 1 à 6, dans lequel l'étape de traitement d'activation de surface (108) du substrat piézoélectrique (106) est un traitement par plasma, en particulier par plasma à base d'oxygène.

10. Procédé de fabrication d'un substrat donneur selon une des revendications 1 à 9, dans lequel le substrat piézoélectrique (106) est un substrat de Tantalate de Lithium (LTO), de Niobate de Lithium (LNO), de Nitrure d'Aluminium (AIN), de Titano-Circonate de Plomb (PZT), de Langasite ou de Langatate.

11. Procédé de fabrication d'un substrat donneur selon une des revendications 1 à 10, dans lequel une étape d'amincissement du substrat piézoélectrique (106) du substrat donneur (128) est réalisée, en particulier par meulage.

12. Procédé de transfert d'une couche piézoélectrique sur un substrat support comprenant les étapes de:
- fournir un substrat donneur (128, 138) obtenu par la mise en œuvre du procédé de fabrication selon la revendication 11,
- former une zone de fragilisation (146) à l'intérieur du substrat piézoélectrique (106) du substrat donneur (128, 138),
- fournir un substrat support (140), en particulier un substrat à base de silicium,
- attacher le substrat donneur (128, 138) au substrat support (140) pour obtenir un assemblage substrat support - substrat donneur (156), et
- réaliser la fracture le long de la zone de fragilisation (146) pour séparer une couche piézoélectrique (148) du restant (158) du substrat donneur (156).

## Patentansprüche

1. Verfahren zur Herstellung eines Donorsubstrats für die Übertragung einer piezoelektrischen Schicht auf ein Trägersubstrat (140), umfassend die folgenden Schritte:
- Bereitstellen eines Handhabungssubstrats (100), insbesondere eines Substrats auf Siliziumbasis,
- Bereitstellen eines piezoelektrischen Substrats (106),
- Aufbringen einer Polymerschicht (104) auf eine freie Oberfläche (110) des piezoelektrischen Substrats (106),
- Zusammenfügen des piezoelektrischen Substrats (106) auf dem Handhabungssubstrat (100) derart, dass die Polymerschicht (104) zwischen dem piezoelektrischen Substrat (106) und dem Handhabungssubstrat (100) positioniert ist,
**dadurch gekennzeichnet, dass**
ein Schritt der Oberflächenaktivierungsbehandlung (108) der Oberfläche (110) des piezoelektrischen Substrats (106), die mit der Polymerschicht (104) in Kontakt kommt, vor dem Schritt zum Zusammenbau des piezoelektrischen Substrats (106) auf dem Handhabungssubstrat (100) durchgeführt wird.

2. Verfahren zur Herstellung eines Donorsubstrats nach Anspruch 1, wobei die Polymerschicht (104) direkt auf die aktivierte Oberfläche (112) des piezoelektrischen Substrats (106) aufgebracht wird.

3. Verfahren zur Herstellung eines Donorsubstrats für die Übertragung einer piezoelektrischen Schicht auf ein Trägersubstrat (140), umfassend die folgenden Schritte:
- Bereitstellen eines Handhabungssubstrats (100), insbesondere eines Substrats auf Siliziumbasis,
- Aufbringen einer Polymerschicht (152) auf eine freie Oberfläche (102) des Handhabungssubstrats (100),
- Zusammenfügen eines piezoelektrischen Substrats (106) auf dem Handhabungssubstrat (100) derart, dass die Polymerschicht (152) zwischen dem piezoelektrischen Substrat (106) und dem Handhabungssubstrat (100) positioniert ist,
**dadurch gekennzeichnet, dass**
ein Schritt der Oberflächenaktivierungsbehandlung (108) der Oberfläche (110) des piezoelektrischen Substrats (106), das beim Zusammenfügungsschritt mit der Polymerschicht (152) des Handhabungssubstrats (100) in Kontakt kommt, vor dem Montageschritt des piezoelektrischen Substrats (106) auf dem Handhabungssubstrat (100) durchgeführt wird.

4. Verfahren zur Herstellung eines Donorsubstrats nach Anspruch 3, wobei bei dem Schritt des Aufbringens der Polymerschicht (152) die Polymerschicht (152) direkt auf dem Handhabungssubstrat (100) positioniert wird.

5. Verfahren zur Herstellung eines Donorsubstrats nach einem der Ansprüche 1 bis 4, wobei der Zusammenfügungsschritt einen Behandlungsschritt (108) der Polymerschicht (104, 152) umfasst, um eine vernetzte Polymerschicht (120) zu erhalten, um das Handhabungssubstrat (100) an das piezoelektrische Substrat (106) zu kleben.

6. Verfahren zur Herstellung eines Donorsubstrats nach einem der Ansprüche 1 bis 5, wobei der Schritt der Oberflächenaktivierungsbehandlung (108) eine sauerstoffbasierte Oberflächenaktivierungsbehandlung (108) ist, die ungesättigte Bindungen auf der Oberfläche (110) des piezoelektrischen Substrats (106) erzeugt, die mit der Polymerschicht (104, 152) in Kontakt kommt.

7. Verfahren zur Herstellung eines Donorsubstrats nach einem der Ansprüche 1 bis 6, wobei der Schritt der Oberflächenaktivierungsbehandlung (108) des piezoelektrischen Substrats (106) eine Ozonbehandlung, insbesondere durch ein Nassverfahren oder ein UV-unterstütztes Verfahren, ist.

8. Verfahren zur Herstellung eines Donorsubstrats nach einem der Ansprüche 1 bis 6, wobei der Schritt der Oberflächenaktivierungsbehandlung (108) des piezoelektrischen Substrats (106) eine Behandlung mit einer Lösung auf Wasserstoffperoxidbasis ist.

9. Verfahren zur Herstellung eines Donorsubstrats nach einem der Ansprüche 1 bis 6, wobei der Schritt der Oberflächenaktivierungsbehandlung (108) des piezoelektrischen Substrats (106) eine Plasmabehandlung, insbesondere eine Behandlung mit sauerstoffbasiertem Plasma, ist.

10. Verfahren zur Herstellung eines Donorsubstrats nach einem der Ansprüche 1 bis 9, wobei das piezoelektrische Substrat (106) ein Substrat aus Lithiumtantalat (LTO), Lithiumniobat (LNO), Aluminiumnitrid (AIN), Bleititanatzirkonat (PZT), Langasit oder Langatat ist.

11. Verfahren zur Herstellung eines Donorsubstrats nach einem der Ansprüche 1 bis 10, wobei ein Schritt zum Ausdünnen des piezoelektrischen Substrats (106) des Donorsubstrats (128) durchgeführt wird, insbesondere durch Schleifen.

12. Verfahren zum Übertragen einer piezoelektrischen Schicht auf ein Trägersubstrat, umfassend die folgenden Schritte:
- Bereitstellen eines Donorsubstrats (128, 138), das durch Durchführung des Verfahrens zur Herstellung nach Anspruch 11 erhalten wird,
- Bilden eines Versprödungsbereichs (146) innerhalb des piezoelektrischen Substrats (106) des Donorsubstrats (128, 138),
- Bereitstellen eines Trägersubstrats (140), insbesondere eines Substrats auf Siliziumbasis,
- Befestigen des Donorsubstrats (128, 138) an dem Trägersubstrat (140), um eine Trägersubstrat-Donorsubstrat-Baugruppe (156) zu erhalten, und
- Durchführen des Bruchs entlang des Versprödungsbereichs (146), um eine piezoelektrische Schicht (148) vom Rest (158) des Donorsubstrats (156) zu trennen.

## Claims

1. A method for producing a donor substrate for transferring a piezoelectric layer onto a carrier substrate (140) comprising the steps of:
- providing a handling substrate (100), in particular a silicon-based substrate,
- providing a piezoelectric substrate (106),
- depositing a polymer layer (104) over a free face (110) of the piezoelectric substrate (106),
- assembling the piezoelectric substrate (106) on the handling substrate (100) such that the polymer layer (104) is sandwiched between the piezoelectric substrate (106) and the handling substrate (100),
**characterised in that**
a step of surface-activating (108) the surface (110) of the piezoelectric substrate (106) in contact with the polymer layer (104) is carried out before the step of assembling the piezoelectric substrate (106) on the handling substrate (100).

2. The method for producing a donor substrate according to claim 1, wherein the polymer layer (104) is deposited directly over the activated surface (112) of the piezoelectric substrate (106).

3. The method for producing a donor substrate for transferring a piezoelectric layer onto a carrier substrate (140) comprising the steps of:
- providing a handling substrate (100), in particular a silicon-based substrate,
- depositing a polymer layer (152) over a free face (102) of the handling substrate (100),
- assembling a piezoelectric layer (106) on the handling substrate (100) such that the polymer layer (152) is sandwiched between the piezoelectric substrate (106) and the handling substrate (100),
**characterised in that**
a step of surface-activating (108) the surface (110) of the piezoelectric substrate (106) in contact with the polymer layer (152) of the handling substrate (100) during the assembly step is carried out before the step of assembling the piezoelectric substrate (106) on the handling substrate (100).

4. The method for producing a donor substrate according to claim 3, wherein, during the step of depositing the polymer layer (152), the polymer layer (152) is positioned directly over the handling substrate (100).

5. The method for producing a donor substrate according to one of claims 1 to 4, wherein the assembly step comprises a step of treating (108) the polymer layer (104, 152) to obtain a cross-linked polymer layer (120) to bond the handling substrate (100) to the piezoelectric substrate (106).

6. The method for producing a donor substrate according to one of claims 1 to 5, wherein the surface-activation treatment step (108) is an oxygen-based surface activation (108), creating dangling bonds on the surface (110) of the piezoelectric substrate (106) in contact with the polymer layer (104, 152).

7. The method for producing a donor substrate according to one of claims 1 to 6, wherein the step of surface-activation treating (108) the piezoelectric substrate (106) is an ozone treatment, in particular a wet ozone treatment or an UV-assisted ozone treatment.

8. The method for producing a donor substrate according to one of claims 1 to 6, wherein the step of surface-activation treating (108) the piezoelectric substrate (106) is a hydrogen peroxide-based solution treatment.

9. The method for producing a donor substrate according to one of claims 1 to 6, wherein the step of surface-activation treating (108) the piezoelectric substrate (106) is a plasma treatment, in particular an oxygen-based plasma treatment.

10. The method for producing a donor substrate according to one of claims 1 to 9, wherein the piezoelectric substrate (106) is a lithium tantalate (LTO), lithium niobate (LNO), aluminium nitride (AIN), lead zirconate titanate (PZT), langasite or langatate substrate.

11. The method for producing a donor substrate according to one of claims 1 to 10, wherein a step of thinning the piezoelectric substrate (106) of the donor substrate (128) is carried out, in particular by grinding.

12. A method for transferring a piezoelectric layer onto a carrier substrate comprising the steps of:
- providing a donor substrate (128, 138) obtained by implementing the production method according to claim 11,
- forming an embrittlement area (146) inside the piezoelectric substrate (106) of the donor substrate (128, 138),
- providing a carrier substrate (140), in particular a silicon-based substrate,
- attaching the donor substrate (128, 138) to the carrier substrate (140) to obtain a carrier substrate - donor substrate assembly (156), and
- fracturing along the embrittlement area (146) to separate a piezoelectric layer (148) from the rest (158) of the donor substrate (156).
